# FASCICULE DE BREVET EUROPEEN

(11) **EP 0 359 082 B1**
(45) Date de publication et mention de la délivrance du brevet: **08.09.1993**
(21) Numéro de dépôt: 89116276.0
(22) Date de dépôt: 04.09.1989
(51) Int. Cl.: G02F 1/13

(54) **Cellule électro-optique perfectionnée**
Elektrooptische Zelle
Electro-optical cell

(30) Priorité: 16.09.1988 CH 3468/88; 26.09.1988 FR 8812639
(43) Date de publication de la demande: 21.03.1990
(73) Titulaire: ASULAB S.A., CH-2502 Bienne (CH)
(72) Inventeur: Grupp, Joachim, CH-2034 Peseux (CH); Ruedin, Yves, CH-2072 Saint-Blaise (CH)
(74) Mandataire: Caron, Gérard

(56) Documents cités:
- EP-A- 0 201 938
- FR-A- 2 399 704
- GB-A- 2 160 693
- US-A- 3 781 087
- US-A- 3 914 021
- PATENT ABSTRACTS OF JAPAN, vol. 8, no. 82 (P-268)[1519], 14 avril 1984, page 142 P 268; JP-A-59 133
- PATENT ABSTRACTS OF JAPAN, vol. 10, no. 374 (P-527)[2431], 12 décembre 1986, page 78 P 527; & JP-A-61 167 925
- ELECTRONICS, vol. 47, no. 19, septembre 1974, pages 122-125; L.S. BUCHOFF: "Conductive elastomers make small, flexible contacts"

## Description

L'invention concerne une cellule électro-optique perfectionnée, et plus particulièrement des moyens de connexion destinés à établir une liaison électrique respectivement entre les électrodes de la cellule et son dispositif de commande.

Une cellule électro-optique, telle qu'une cellule à cristal liquide décrite notamment dans les brevets US 3 781 087 et US 3 781 088 comprend généralement un film de cristal liquide intercalé entre deux lames de verre recouvertes chacune sur leur face en regard d'électrodes reliées à un dispositif de commande. Les lames sont réunies entre elles par un cadre de scellement s'étendant le long du pourtour de ces dernières. Les électrodes sont recouvertes d'une première couche dite couche diélectrique, et d'une seconde couche dite couche d'alignement. La première couche est destinée à augmenter la résistivité de la cellule tandis que la seconde couche permet d'orienter les molécules du cristal qui se trouvent dans son voisinage dans une direction homogène parallèle aux lames.

Pour procéder à la connexion électrique entre les électrodes et le dispositif de commande, (à l'aide d'une soudure ou analogue), on décale légèrement les lames l'une par rapport à l'autre si bien que l'on peut accéder directement à une partie plane des électrodes et réaliser aisément la connexion sur la surface ainsi dégagée.

Cependant, une telle technique nécessite des opérations de préparation de la surface sur laquelle on désire connecter.

En effet, les deux dépôts superficiels qui recouvrent les électrodes constituent une couche isolante à travers laquelle il est difficile de réaliser un contact satisfaisant. Pour pallier ce problème, on est contraint de réaliser un masquage au moment du dépôt des couches superficielles afin de rendre les électrodes directement accessibles à des endroits déterminés en vue de leur connexion ultérieure.

Par conséquent, un tel dépôt sélectif nécessite des opérations supplémentaires coûteuses et consommatrices de temps qu'il convient de supprimer.

Une autre possibilité pour pallier le problème évoqué ci-dessus consiste à éliminer sélectivement la couche isolante en masquant le reste de la surface par un procédé du type photolithographique. Cela conduit là encore à des opérations longues et coûteuses.

Enfin, une solution moins technologique consiste à gratter cette couche isolante, mais compte tenu des épaisseurs des couches (de l'ordre de quelques centaines d'Angströms), la discrimination de celles-ci lors du grattage est impossible et le contact que l'on obtient n'est pas non plus satisfaisant.

L'invention a donc pour but principal de remédier aux inconvénients de l'art antérieur décrit ci-dessus en fournissant une cellule électro-optique perfectionnée dont la connexion des électrodes avec le dispositif de commande est réalisée de façon simple, rapide et économique.

A cet effet, la présente invention a pour objet une cellule électro-optique comprenant :
- une première lame avant transparente,
- une seconde lame arrière,
- un cadre de scellement interposé entre lesdites première et seconde lames,
- au moins une électrode s'étendant à la surface de chaque lame venant au moins partiellement affleurer la tranche de la lame correspondante pour y définir une zone de contact,
- une matière dont les caractéristiques électro-optiques sont susceptibles d'être modifiées par un signal de commande, emprisonnée dans le volume défini par les lames et le cadre de scellement,
- lesdites électrodes étant destinées à être reliées à un dispositif de commande pour y appliquer sélectivement ledit signal de commande,
- et des moyens de connexion pour établir des liaisons électriques respectivement entre chaque électrode et ledit dispositif de commande.

Conformément à l'invention, lesdits moyens de connexion comprennent un plot de contact réalisé en une matière adhésive synthétique chargée de particules conductrices et apportée sur la tranche de chaque lame dans ladite zone de contact, ledit plot de contact assurant à la fois la liaison électrique et la liaison mécanique avec au moins un autre élément desdits moyens de connexion.

Ainsi, on assure une connexion simple et sûre des électrodes avec le dispositif de commande et cela sans recourir à des opérations de masquage des points de connexion lors du dépôt de la couche diélectrique et de la couche d'alignement sur les électrodes.

Et en outre, la réalisation d'une telle connexion protège les électrodes de la corrosion.

Selon un mode avantageux de réalisation, la matière synthétique adhésive fait partie de la famille chimique des résines époxydes, et les particules conductrices sont des particules métalliques.

D'autres caractéristiques et avantages de l'invention apparaîtront à la lecture de la description qui suit des modes de réalisation non limitatifs en liaison avec les dessins ci-joints parmi lesquels :
- la figure 1 montre une vue en coupe d'un rétroviseur pour véhicule automobile dans lequel est incorporé une cellule électrooptique perfectionnée selon l'invention,
- la figure 2 est une vue à grande échelle de la partie entourée par un trait mixte et désignée par la lettre A sur la figure 1,
- les figures 3 et 4 sont des vues partielles en coupe de deux variantes de réalisation de l'invention,
- la figure 5 est une vue en coupe de dessus d'une cellule électro-optique reliée à un support de circuit imprimé selon l'invention, et
- la figure 6 est une vue en coupe selon la ligne VI-VI de la figure 5.

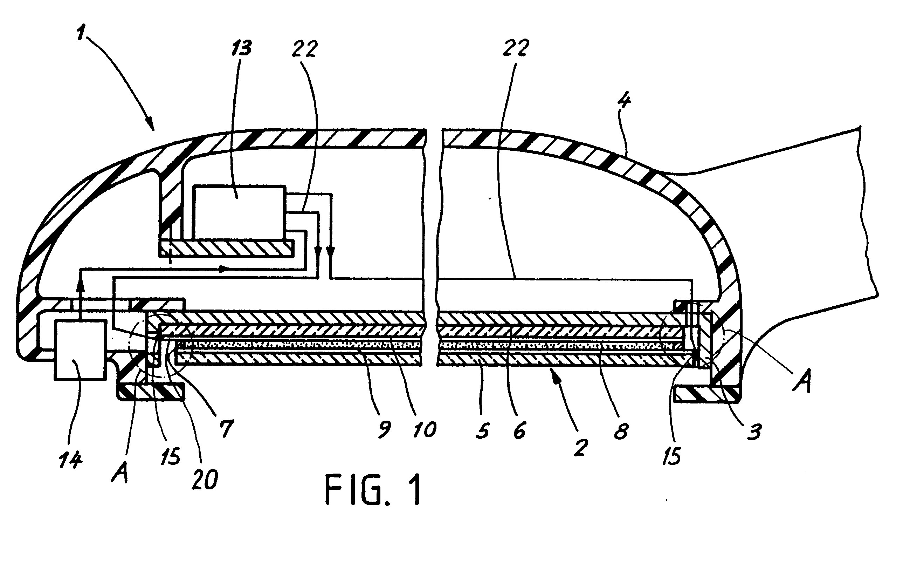

En se référant tout d'abord à la figure 1, on voit un rétroviseur pour véhicule automobile désigné par la référence générale 1 comprenant une cellule à cristal liquide perfectionnée 2 selon l'invention. A titre d'exemple, la cellule est de forme générale rectangulaire.

La cellule 2 est montée dans un cadre 3, ce dernier étant fixé par collage dans le boîtier 4 du rétroviseur 1.

Cette cellule 2 comprend, de manière connue, une lame avant 5 transparente ayant subi un traitement anti-reflet et une lame arrière 6, les deux lames 5 et 6 étant réunies entre elles par un cadre de scellement 7 définissant un volume étanche dans lequel est emprisonné un mélange 8 composé d'un cristal liquide nématique et d'un colorant dichroïque.

La lame 5 avant porte sur sa face interne, une électrode 9 transparente s'étendant sur la totalité de la lame, par exemple un mélange d'oxyde d'indium/étain, ainsi qu'une couche diélectrique et une couche d'alignement non représentées sur cette figure.

Par ailleurs, la lame arrière 6 porte sur la totalité de sa face interne une contre-électrode 10, une couche réfléchissante pouvant constituer ladite contre-électrode, et une couche diélectrique et une couche d'alignement également non représentées.

On voit également un boîtier de commande électrique 13 qui comprend une entrée reliée à un capteur photo-sensible 14, ce boîtier délivrant un signal de commande représentatif de l'intensité de la lumière reçue par le capteur, vers deux sorties reliées respectivement à l'électrode 9 et la contre-électrode 10 afin de commander le degré d'absorption de la cellule 2.

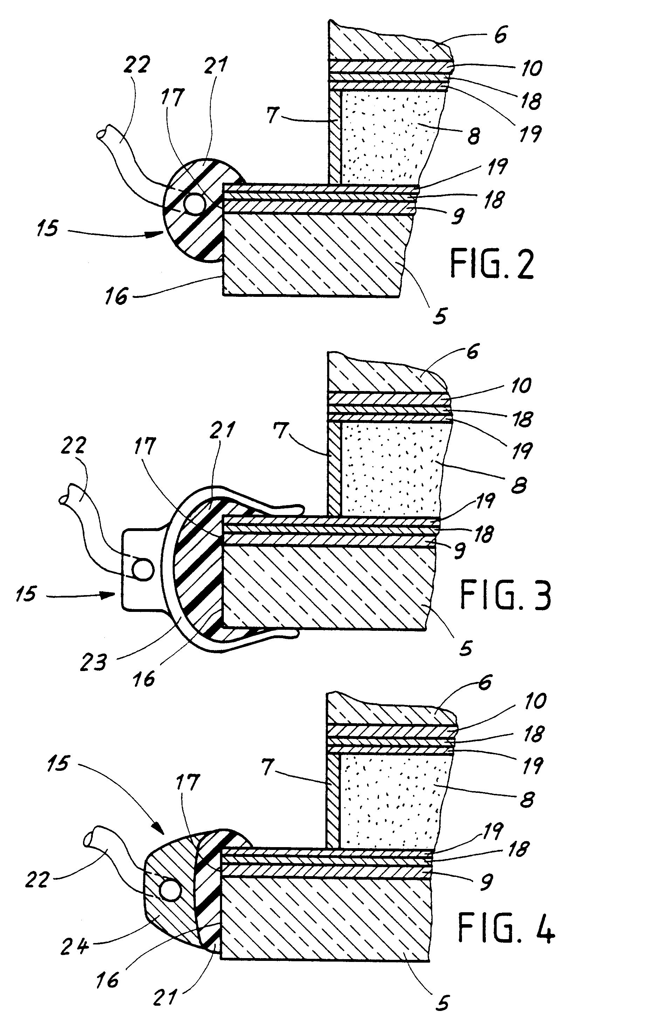

Enfin on voit, entourés par un cercle en trait interrompu désigné par la lettre A, des moyens de connexion 15. Selon l'invention, ces moyens de connexion 15 sont destinés à établir une liaison électrique respectivement entre chaque électrode 9, 10 et le dispositif de commande 13 qui seront décrits plus en détail dans ce qui suit en référence aux figures 2 à 4.

En se référant à la figure 2, on voit une vue agrandie des moyens de connexion 15 représentés à la figure 1.

Les électrodes 9, 10 recouvrent respectivement la totalité des lames 5, 6 et lesdites électrodes viennent affleurer la tranche 16 des lames pour y définir une zone de contact 17. Cette zone de contact 17 s'étend le long du pourtour de chaque lame 5, 6.

Les électrodes 9, 10 sont totalement recouvertes par la couche diélectrique 18 et la couche d'alignement 19. Ces couches 18 et 19 s'étendent aussi à la surface des lames pour venir affleurer la tranche 16 si bien qu'un contact avec les électrodes 8, 9 ne peut pas être réalisée directement par la surface 20.

Pour fixer les idées, on notera que l'épaisseur des électrodes et celles des deux autres couches susdites sont de l'ordre de quelques centaines d'Angströms.

Selon l'invention, les moyens de connexion 15 comprennent un plot de contact 21 associé à chaque électrode 9, 10. Ce plot de contact 21 est réalisé en une matière adhésive synthétique chargée de particules conductrices et est apportée sur la tranche 16 dans la zone de contact 17 de chacune des lames 5, 6.

Ce plot de contact 21 constitué par la matière adhésive susdite assure donc à la fois la liaison électrique et la liaison mécanique entre un autre élément de connexion relié au dispositif de commande, et à la cellule.

Dans ce cas, ledit autre élément reliant la cellule au dispositif de commande est un fil conducteur 22 dont une extrémité est noyés dans la masse du plot 21.

Pratiquement, le plot 21 est constitué par une colle époxyde conductrice, cette dernière étant chargée de particules d'argent ou analogues. Ce type de colle peut être par exemple obtenu chez "PROTEX" sous la dénomination commerciale "Protonic".

L'application de la colle peut se faire au pinceau ou par tout autre moyen approprié. Toutefois, il faut veiller à ce qu'elle soit apportée en quantité suffisante pour établir un contact intime avec l'électrode afin d'assurer un contact satisfaisant.

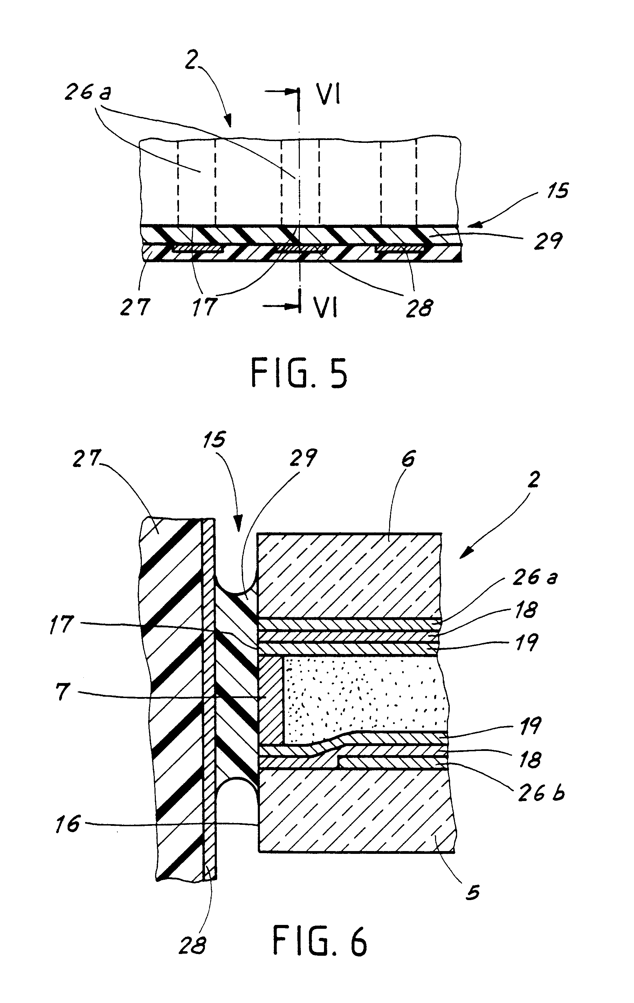

Sur les figures 3 et 4, on voit deux variantes de réalisation d'une cellule perfectionnée selon l'invention dans lesquelles on a désigné les éléments identiques à ceux décrits précédemment par les mêmes références numériques.

Dans la variante de réalisation représentée à la figure 3, après avoir appliqué la colle conductrice dans la zone de contact 17, le plot de contact 21 formé par cette dernière est relié au dispositif de commande au moyen d'une pince 23 qui forme l'autre élément des moyens de connexion selon l'invention.

Cette pince 23 reliée au dispositif de commande 13 par un fil conducteur 22 est disposée pour venir serrer la lame 5 en même temps qu'elle coiffe le plot 21 afin de réaliser le contact électrique. Ainsi la liaison électrique avec le dispositif de commande est réalisée de façon sûre tout en renforçant la liaison mécanique entre la cellule et le fil conducteur.

Avantageusement, le plot 21 remplit la totalité du fond de la pince 23, et la pince est mise en place avant le séchage de la colle.

En se référant maintenant à la variante de réalisation représentée sur la figure 4, le plot de contact 21 constitue un substrat pour une soudure métallique 24 comprenant, noyé dans sa masse, l'extrémité d'un fil conducteur 22 relié au dispositif de commande.

Dans ce cas, le plot de contact 21 réalisé avec la colle conductrice s'étend dans la zone de contact 17 sur une surface suffisamment importante pour que la soudure métallique rapportée puisse réaliser un bon contact électrique en même temps qu'une bonne liaison mécanique avec le plot de contact 21.

On notera que dans les exemples illustrés et précédemment décrits, les lames 5, 6 de la cellule sont légèrement décalées l'une par rapport à l'autre. Dans tous ces cas, le décalage permet simplement de réaliser une connexion de l'électrode portée par chacune des lames sans risquer d'établir des courts-circuits entre elles.

Bien entendu, si l'on désire connecter une cellule selon l'invention sans ce décalage, il suffit de déposer l'électrode sur chacune des lames de sorte que sur au moins un bord latéral de la lame une des électrodes n'affleure pas la tranche de celle-ci.

L'invention est particulièrement intéressante dans le cas de cellules comprenant par lame une seule électrode recouvrant la totalité de la surface de celle-ci, mais on remarquera que cette invention peut être aussi utilisée avantageusement dans des cellules dans lesquelles chaque lame comprend une pluralité d'électrodes déposées sélectivement selon une configuration déterminée notamment dans des cellules classiques d'affichage à cristal liquide.

En effet, dans un autre exemple de réalisation, représenté aux figures 5 et 6, on voit partiellement une cellule d'affichage à cristal liquide 2 comprenant sur chacune des lames 5 et 6, une pluralité d'électrodes 26a, 26b, déposées sélectivement sur celles-ci. Cette cellule 2 est reliée à un dispositif de commande (non représenté) au moyen d'un support de circuit imprimé 27 portant une pluralité de pistes conductrices 28 associées chacune à une électrode 26a.

La connexion entre les pistes conductrices et les électrodes est assurée ici par un joint de colle conductrice anisotrope 29 disposé entre les pistes conductrices 28 portées par le support essentiellement dans la zone de contact 17 associée à chacune des électrodes 26a, située sur la tranche 16 de la cellule.

Comme il ressort clairement de la figure 6, la ou les électrodes 26b portées par la lame 5 ne s'étendent pas jusqu'au bord de cette dernière. Cette configuration permet d'éviter un court circuit entre les électrodes 26b et les électrodes 26a portées par la lame 6 lors de la connexion.

En revanche, on notera que la couche diélectrique 18 et la couche d'alignement 19 n'ont pas été déposé sélectivement et recouvrent la totalité de la surface de la lame 5 ainsi que de la lame 6. On évite insi des opérations de masquage qui auraient été nécessaire avec une connexion classique.

De plus, la connexion du support 27 et de la cellule 2 par la tranche 17 de celle-ci ne nécessite plus le décalage classique des lames et l'ensemble ainsi obtenu est rendu avantageusement compact.

## Revendications

1. Cellule électro-optique comprenant :
- une première lame avant (5) transparente,
- une seconde lame arrière (6),
- un cadre de scellement (7) interposé entre lesdites première et seconde lames (5, 6),
- au moins une électrode (9, 10) s'étendant à la surface de chaque lame venant au moins partiellement affleurer la tranche (16) de la lame correspondante pour y définir une zone de contact (17),
- une matière (8) dont les caractéristiques électro-optiques sont susceptibles d'être modifiées par un signal de commande, emprisonnée dans le volume défini par les lames (5, 6) et le cadre de scellement (7),
- lesdites électrodes (9, 10) étant destinées à être reliées à un dispositif de commande (13) pour y appliquer sélectivement ledit signal de commande,
- et des moyens de connexion (15) pour établir des liaisons électriques respectivement entre chaque électrode (9, 10) et ledit dispositif de commande (13),
lesdits moyens de connexion (15) comprenant chacun un plot de contact (21) réalisé en une matière adhésive synthétique chargée de particules conductrices, caractérisée en ce que chaque plot est apporté sur la tranche (16) de chaque lame (5, 6) dans ladite zone de contact respective (17), ledit plot de contact (21) assurant à la fois la liaison électrique et la liaison mécanique avec au moins un autre élément (22, 23, 24) desdits moyens de connexion.

2. Cellule selon la revendication 1, caractérisée en ce que la matière synthétique adhésive (21) fait partie de la famille chimique des résines époxydes et les particules conductrices sont des particules métalliques.

3. Cellule selon la revendication 1 ou 2, caractérisée en ce que l'un desdits autres éléments des moyens de connexion (15) est une pince (23).

4. Cellule selon la revendication 1 à 3, caractérisée en ce que l'un desdits autres éléments des moyens de connexion (15) est une soudure métallique (24).

5. Cellule selon la revendication 1, caractérisée en ce que la matière synthétique adhésive chargée de particules conductrices est une colle conductrice anisotrope (29).

6. Rétroviseur (1) pour véhicule automobile, caractérisé en ce qu'il comprend une cellule électro-optique (2) selon l'une quelconque des revendications précèdentes, ladite cellule (2) comprenant une lame arrière (6) présentant un revêtement réfléchissant (10).

7. Rétroviseur (1) selon la revendication 6, caractérisé en ce que la matière dont les caractéristiques optiques sont susceptibles d'être modifiées est du cristal liquide (8).

8. Rétroviseur selon la revendication 6 ou 7, caractérisé en ce qu'il comprend en outre un élément (14) susceptible de délivrer un signal de commande représentatif de l'intensité de la lumière atteignant cet élément (14), le dispositif de commande (13) agissant sur la transparence de la cellule (2) en réponse à ce signal de commande.

## Claims

1. Electrooptical cell comprising :
- a first transparent front plate (5),
- a second back plate (6),
- a sealing frame (7) interposed between said first and second plates (5, 6),
- at least one electrode (9, 10) extending along the surface of each plate and which is at least partially flush with the edge (16) of the corresponding plate to define a contact zone (17) there,
- a material (8) having electrooptical characteristics than can be modified by a control signal and enclosed in a volume defined by the plates (5, 6) and the sealing frame (7),
- said electrodes (9, 10) being designed to be connected to a control unit (13) in order to selectively apply said control signal thereon,
- and connection means to establish electrical connections between each electrode (9, 10) and said control unit (13) respectively,
said connection means (15) comprising each a contact block (21) made of a synthetic adhesive material charged with conducting particles, characterized in that each block is applied on the edge (16) of each plate (5, 6) in said respective contact zone (17), said contact block (21) ensuring both the electrical connection and the mechanical bond with at least one other element (22, 23, 24) of said connection means.

2. Cell according to claim 1, characterized in that the synthetic adhesive material (21) is part of the epoxy resin chemical family and the conducting particles are metal particles.

3. Cell according to claim 1 or 2, characterized in that one of the further elements of said connection means (15) is a clip (23).

4. Cell according to claim 1 to 3, characterized in that one of the further elements of said connection means (15) is a metal weld (24).

5. Cell according to claim 1, characterized in that the adhesive synthetic material charged with conducting particles is an anisotropic conducting adhesive (29).

6. Automobile rear view mirror (1), characterized in that it comprises an electrooptical cell (2) according to any one of the preceding claims, said cell (2) comprising a back plate (6) having a reflective coating (10).

7. Rear view mirror (1) according to claim 6, characterized in that the material whose optical characteristics may be modified is a liquid crystal cell (8).

8. Rear view mirror according to claim 6 or 7, characterized in that it further comprises an element (14) adapted to deliver a control signal representing the intensity of the light impinging on this element (14), the control unit (13) acting on the transparency of the cell (2) in response to this control signal.

## Patentansprüche

1. Elektrooptische Zelle, umfassend:
- eine erste transparente vordere Scheibe (5),
- eine zweite hintere Scheibe (6),
- einen Versiegelungsrahmen (7), der zwischen der ersten und der zweiten Scheibe (5, 6) eingefügt ist,
- mindestens eine Elektrode (9, 10), die sich auf der Oberfläche jeder Scheibe erstreckt, indem sie mindestens teilweise bündig ist mit der Kante (16) der entsprechenden Scheibe, um dort eine Kontaktzone (17) zu definieren,
- ein Material (8), dessen elektrooptische Charakteristiken modifizierbar sind durch ein Steuersignal, eingefangen in dem Volumen, das begrenzt wird von den Scheiben (5, 6) und dem Versiegelungsrahmen (7),
- welche Elektroden (9, 10) dazu bestimmt sind, mit einer Steuervorrichtung (13) verbunden zu werden, um an sie selektiv das Steuersignal anzulegen, und
- Verbindungsmittel (15) zum Herstellen der jeweiligen elektrischen Verbindung zwischen jeder Elektrode (9, 10) und der Steuervorrichtung (13), welche Verbindungsmittel (15) jeweils einen Kontaktnocken (21) umfassen, hergestellt aus einem adhäsiven, synthetischen, mit leitenden Partikeln gefüllten Material, dadurch gekennzeichnet, daß jeder Kontaktnocken auf den Rand (16) jeder Scheibe (5, 6) in der jeweiligen Kontaktzone (17) aufgebracht ist, wobei der Kontaktnocken (21) gleichzeitig die elektrische Verbindung und die mechanische Verbindung mit mindestens einem weiteren Element (22, 23, 24) der Verbindungsmittel sicherstellt.

2. Zelle nach Anspruch 1, dadurch gekennzeichnet, daß das synthetische, adhäsive Material (21) zu der chemischen Familie der Epoxidharze gehört und die leitenden Partikel metallische Partikel sind.

3. Zelle nach Anspruch 1 oder 2, dadurch gekennzeichnet, daß eines der weiteren Verbindungsmittelelemente (15) eine Klemme (23) ist.

4. Zelle nach Anspruch 1 bis 3, dadurch gekennzeichnet, daß eines der weiteren Verbindungsmittelelemente (15) ein metallisches Lot (24) ist.

5. Zelle nach Anspruch 1, dadurch gekennzeichnet, daß das synthetische, adhäsive, mit leitenden Partikeln gefüllte Material ein anisotropleitender Kleber (29) ist.

6. Rückspiegel (1) für ein Kraftfahrzeug, dadurch gekennzeichnet, daß er eine elektrooptische Zelle (2) nach einem der vorangehenden Ansprüche umfaßt, welche Zelle (2) eine hintere Scheibe (6) mit einer reflektierenden Beschichtung (10) umfaßt.

7. Rückspiegel (1) nach Anspruch 6, dadurch gekennzeichnet, daß das Material, dessen optische Charakteristiken modifizierbar sind, ein Flüssigkristall (8) ist.

8. Rückspiegel nach Anspruch 6 oder 7, dadurch gekennzeichnet, daß er ferner ein Element (14) umfaßt, das in der Lage ist, ein Steuersignal abzugeben, das repräsentativ ist für die Intensität des auf dieses Element (14) auftreffenden Lichtes, wobei die Steuervorrichtung (13) auf die Transparenz der Zelle (2) im Ansprechen auf dieses Steuersignal einwirkt.
